(19) Europäisches Patentamt
European Patent Office
Office européen des brevets

(11) Veröffentlichungsnummer: **0 259 727**
**A2**

# (12) EUROPÄISCHE PATENTANMELDUNG

(21) Anmeldenummer: **87112572.0**

(51) Int. Cl.⁴: **G03F 7/10**, G03C 1/68

(22) Anmeldetag: **28.08.87**

(30) Priorität: **11.09.86 DE 3630956**

(43) Veröffentlichungstag der Anmeldung: **16.03.88 Patentblatt 88/11**

(84) Benannte Vertragsstaaten: **AT BE CH DE FR GB IT LI LU NL SE**

(71) Anmelder: **Siemens Aktiengesellschaft Berlin und München**
**Wittelsbacherplatz 2**
**D-8000 München 2(DE)**

(72) Erfinder: **Ahne, Hellmut, Dr.**
**Heidestrasse 6**
**D-8551 Röttenbach(DE)**
Erfinder: **Plundrich, Winfried**
**Stahlstrasse 13**
**D-8500 Nürnberg(DE)**

## (54) Verfahren zur Herstellung wärmebeständiger strukturierter Schichten auf Epoxidharzbasis.

(57) Wärmebeständige strukturierte Schichten lassen sich - durch Auftragen strahlungsempfindlicher löslicher Polymerer in Form einer Schicht oder Folie auf ein Substrat, Bestrahlen der Schicht bzw. Folie durch Negativvorlagen mit aktinischem Licht oder durch Führen eines Licht-, Elektronen-, Laser-oder Ionenstrahls, Entfernen der nicht-bestrahlten Schicht-bzw. Folienteile und gegebenenfalls durch nachfolgendes Tempern - dann in kostengünstiger Weise dimensionsgenau und in qualitativ hochwertiger Form herstellen, und zwar in einem einzigen Beschichtungsvorgang, wenn Photopolymere auf Epoxidharzbasis in Form von Additionsprodukten von olefinisch ungesättigten Monoisocyanaten mit hydroxylgruppenhaltigen Epoxiden verwendet werden. Die nach diesem Verfahren hergestellten Schichten halten auch den thermischen und mechanischen Beanspruchungen bei Tauchlötprozessen stand und schützen Schaltungsoberflächen wirksam und dauerhaft gegen Feuchte und Korrosion; sie eignen sich daher insbesondere als Lötstopp-und Isolierschicht in der Feinleitertechnik.

EP 0 259 727 A2

## Verfahren zur Herstellung wärmebeständiger strukturierter Schichten auf Epoxidharzbasis

Die Erfindung betrifft ein Verfahren zur Herstellung wärmebeständiger strukturierter Schichten auf Epoxidharzbasis durch Auftragen strahlungsempfindlicher löslicher Polymerer in Form einer Schicht oder Folie auf ein Substrat, Bestrahlen der Schicht bzw. Folie durch Negativvorlagen mit aktinischem Licht oder durch Führen eines Licht-, Elektronen-, Laser-oder lonenstrahls, Entfernen der nicht-bestrahlten Schicht- bzw. Folienteile und gegebenenfalls durch nachfolgendes Tempern, sowie die Verwendung dieser strukturierten Schichten.

Verfahren zur Herstellung strukturierter Schichten auf der Basis wärmebeständiger Polymerer sind beispielsweise aus der deutschen Patentschrift 2 308 830 sowie aus den europäischen Patentschriften 0 019 123 und 0 026 820 bekannt. Bei diesen Verfahren werden lösliche photoreaktive Vorstufen hochwärmebeständiger Polymerer zur photolithographischen Strukturierung eingesetzt und die daraus hergestellten Strukturen in einem anschließenden Temperschritt zu hochwärmebeständigen Strukturen cyclisiert. Für die vollständige Cyclisierung und die Entfernung der Spaltprodukte werden Temperaturen bis zu 400°C benötigt. Dies erfordert thermisch hochbelastbare Substrate.

Auf dem Schaltungs-und Leitungssektor, beispielsweise in der Leiterplattentechnik, werden unter anderem Substrate auf Epoxidbasis verwendet, die thermisch maximal bis zu ca. 150°C/1 h belastet werden können und die nur im Sekundenbereich Temperaturen von ca. 280°C standhalten müssen, bei spielsweise bei Lötprozessen. Die hier zur partiellen Leiterbahnabdeckung eingesetzten sogenannten Lötstopplacke müssen ähnlichen thermischen Anforderungen entsprechen, d.h. hierbei werden zur Abdeckung der Stellen der Schaltungsoberfläche, die nicht mit dem Lotmetall in Kontakt treten sollen, Polymere mit einer mittleren thermischen Beständigkeit benötigt. Die bisher zu diesem Zweck (noch) eingesetzten Trockenresists bzw. Siebdrucklacke auf Epoxid-und Acrylatbasis entsprechen zwar den Anforderungen einer Lötstoppmaske, erfüllen jedoch nur zum Teil die gestiegenen Anforderungen an die Maßgenauigkeit in der Feinstleitertechnik mit Strukturen <100 $\mu$m, sowie die geforderte Cycelfestigkeit. Hierfür werden photolithographische Lacksysteme benötigt.

Es ist zwar bereits ein photostrukturierbares Lacksystem auf Epoxidbasis mit in die Polymerkette eingebauten Chalkongruppen, d.h. Gruppen der Struktur $-C_6H_4-CH=CH-CO-C_6H_4-$, verfügbar, das eine ausreichende Maßgenauigkeit gewährleistet (siehe: "Chimia", Bd. 38 (1984), Seiten 13 bis 20). Was die Photostrukturierbarkeit anbetrifft, sind hierbei jedoch relativ lange Belichtungszeiten und insbesondere lange Entwicklungszeiten erforderlich. Darüber hinaus kann mit dem bekannten Lacksystem ein zusätzlicher dauerhafter Schutz der gegen Schadgas empfindlichen Schaltungsoberfläche, wie er oft gefordert wird, nur durch eine aufwendige Mehrfachbeschichtung erreicht werden. Ferner ist der Prozeßablauf, bedingt durch mehrstündige Nachhärtungszeiten, lang und kostenintensiv.

Aufgabe der Erfindung ist es, ein Verfahren der eingangs genannten Art in der Weise auszugestalten, daß es möglich ist, dimensionsgenaue, qualitativ hochwertige strukturierte Schichten auf Epoxidharzbasis, insbesondere auf Schaltungsoberflächen, in einem einzigen Beschichtungsvorgang herzustellen, die auch den umfangreichen thermischen und mecha nischen Beanspruchungen, beispielsweise bei Tauchlötprozessen, standhalten und darüber hinaus die Schaltungsoberfläche wirksam und dauerhaft gegen Feuchte und Korrosion schützen. Insbesondere soll der Prozeßdurchlauf durch kurze Belichtungs-, Entwicklungs-und Temperzeiten verkürzt und dadurch kostengünstig gestaltet werden.

Dies wird erfindungsgemäß dadurch erreicht, daß Photopolymere in Form von Additionsprodukten von olefinisch ungesättigten Monoisocyanaten mit hydroxylgruppenhaltigen Epoxiden verwendet werden.

Das erfindungsgemäße Verfahren erlaubt - im Rahmen eines kostengünstigen Prozeßablaufes - die Herstellung feinstrukturierter Schutz-und Isolierschichten für den Halbleiter-und Schaltungssektor, die die gegen Korrosion empfindlichen Bauteile und Schaltungen dauerhaft wirksam schützen. Besonders vorteilhaft ist dabei, daß der Entwicklungsprozeß nicht zum Unterlösen führt und somit bei Lötprozessen keine Lotbrücken auftreten. Das erfindungsgemäße Verfahren erfüllt ferner nicht nur die hinsichtlich der Maßgenauigkeit der erzeugten Strukturen gestellten Anforderungen, sondern es ermöglicht darüber hinaus eine sehr hohe Auflösung in einem breiten Schichtdickenbereich mit kurzen Entwicklungszeiten. Dieses Verfahren ist ferner kostengünstig, insbesondere auch deshalb, weil es bei einmaligem Auftrag (mit konventionellem Equipment) - gegebenenfalls nach kurzzeitiger Temperung - photostrukturierte Schichten mit ausreichend hoher Wärmebeständigkeit ergibt, die - auch unter Lötbadbedingungen - formstabil und rißfrei bleiben und als dauerhafter Schutz gegen Feuchte und Korrosion wirksam sind. Die guten elektrischen Kennwerte werden dabei auch im Feuchteklima nicht beeinträchtigt. Strukturierte Isolierstoffschichten der vorstehend genannten Art eignen sich somit insbesondere als Lötschutz und als dauerhafter Schutz auf Leiterplatten substraten, und zwar mit Kupfer-oder Kupferoxid-Leiterbahnoberflächen.

Beim erfindungsgemäßen Verfahren können die Photopolymeren vorteilhaft zusammen mit licht-oder strahlungsempfindlichen copolymerisationsfähigen Verbindungen eingesetzt werden. Dazu werden vorzugsweise acrylat-und methacrylatgruppenhaltige Verbindungen verwendet, insbesondere Trimethylolpropantriacrylat und -methacrylat und/oder 1.4-Butandioldimethacrylat. Es können aber auch allylgruppenhaltige Verbindungen, beispielsweise Diallyl-und Triallylcyanurate, sowie N-substituierte Maleinimide eingesetzt werden. Weiter können auch Photoinitiatoren und/oder -sensibilisatoren verwendet werden (vgl.: "Industrie Chimique Belge", Vol. 24, 1959, Seiten 739 bis 764, sowie J.Kosar, "Light-Sensitive Systems", John Wiley & Sons Inc., New York 1965, Seiten 143 bis 146 und 160 bis 188). Besonders geeignet sind $\alpha$-Halogenacetophenone, Dialkoxyacetophenone, wie Dimethoxy-und Diethoxyacetophenon, Benzoylphosphinoxide, die gegebenenfalls substituiert sein können, und Michler's Keton. Als Photoinitiatoren bzw. -sensibilisatoren eignen sich beispielsweise aber auch Benzoinether, 4.4′ -Bis(diethylamino)-benzophenon, 2.6-Bis-(p-azidobenzyliden)-4-methylcyclohexanon, Thioxanthone, wie Isopropylthioxanthon, und Acetophenon. Ferner können beim erfindungsgemäßen Verfahren vorteilhaft Haftvermittler verwendet werden. Dazu dienen insbesondere Silane, wie Vinyltriethoxysilan, Vinyl-tris($\beta$-methoxyethoxy)-silan, $\gamma$-Methacryloxypropyl-trimethoxysilan, $\gamma$-Glycidoxypropyl-trimethoxysilan und $\gamma$-Aminopropyl-triethoxysilan.

Den Lösungen der Photopolymeren werden vorzugsweise Härter zugesetzt, wie sie üblicherweise zur Aushärtung von Epoxidharzen verwendet werden. Ferner können den Lösungen vorteilhaft auch mineralische Füllstoffe, insbesondere auf Siliciumdioxid-und Aluminiumoxidbasis, sowie weitere, üblicherweise eingesetzte Füllstoffe zugegeben werden.

Die beim erfindungsgemäßen Verfahren eingesetzten Photopolymeren sind in der gleichzeitig eingereichten europäischen Patentanmeldung "Photopolymere auf Epoxidharzbasis", Anmeldenummer ......... (VPA 86 P 3326 E), beschrieben. Diese Photopolymeren weisen im allgemeinen folgende Struktur auf:

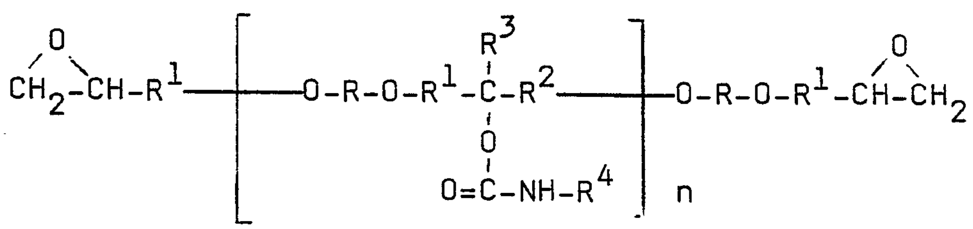

Dabei liegt n zwischen 1 und 20.

Für R, $R^1$, $R^2$, $R^3$ und $R^4$ gilt folgendes:

R ist ein - gegebenenfalls halogenierter - divalenter, d.h. difunktioneller Rest aromatischer und/oder aliphatischer und/oder cycloaliphatischer, gegebenenfalls Heteroatome aufweisender, und/oder heterocyclischer Struktur;

$R^1$ ist ein divalenter aliphatischer Rest;

$R^2$ ist ein - gegebenenfalls halogensubstituierter - divalenter aliphatischer und/oder cycloaliphatischer Rest;

$R^3$ ist Wasserstoff oder eine - gegebenenfalls halogensubstituierte - Alkylgruppe;

$R^4$ ist eine über eine aliphatische und/oder cycloaliphatische und/oder aromatische Brücke gebundene olefinisch ungesättigte Gruppe, beispielsweise eine allylether-oder maleinimidhaltige Gruppe und insbesondere eine - gegebenenfalls substituierte - (meth)acrylesterhaltige Gruppe.

Den Photopolymeren liegen vorzugsweise Epoxidharze mit aromatischen Partialstrukturen zugrunde. Die aromatischen Partialstrukturen können dabei vorteilhaft halogeniert, insbesondere bromiert, sein. Die Epoxide selbst besitzen vorzugsweise ein Epoxidäquivalentgewicht zwischen 600 und 6000, insbesondere zwischen 2400 und 4000.

Bevorzugt eingesetzte Photopolymere sind Additionsprodukte von Isocyanatoethylmethacrylat und aromatische Partialstrukturen aufweisenden Epoxidharzen, welche - gegebenenfalls fluorierte - Isopropylgruppen aufweisen, oder Additionsprodukte von - gegebenenfalls kernbromierte - aromatische Partialstrukturen aufweisenden Epoxidharzen mit olefinisch ungesättigten Monoisocyanaten in Form von Additionsprodukten aus 2.4-Diisocyanatotoluol und Hydroxyethylacrylat oder -methacrylat. Derartige Photopolymere sind in den nachfolgenden Formeln (1) und (2) beispielhaft verdeutlicht.

(1)

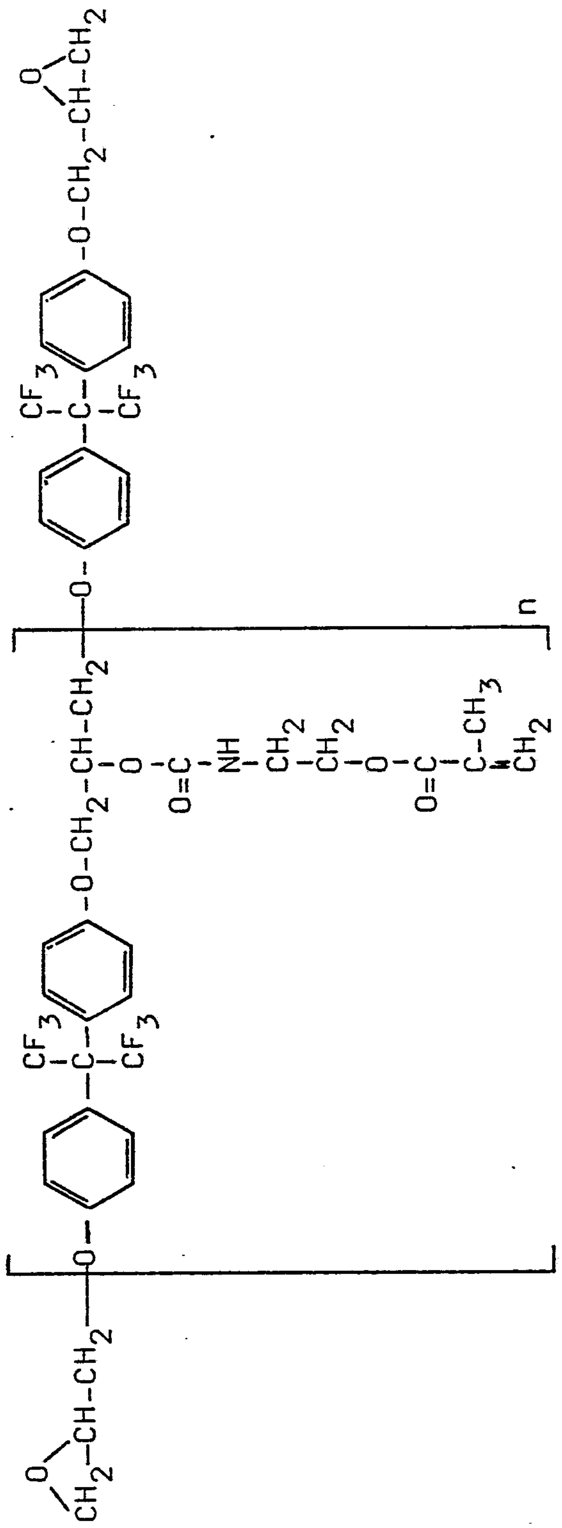

(2)

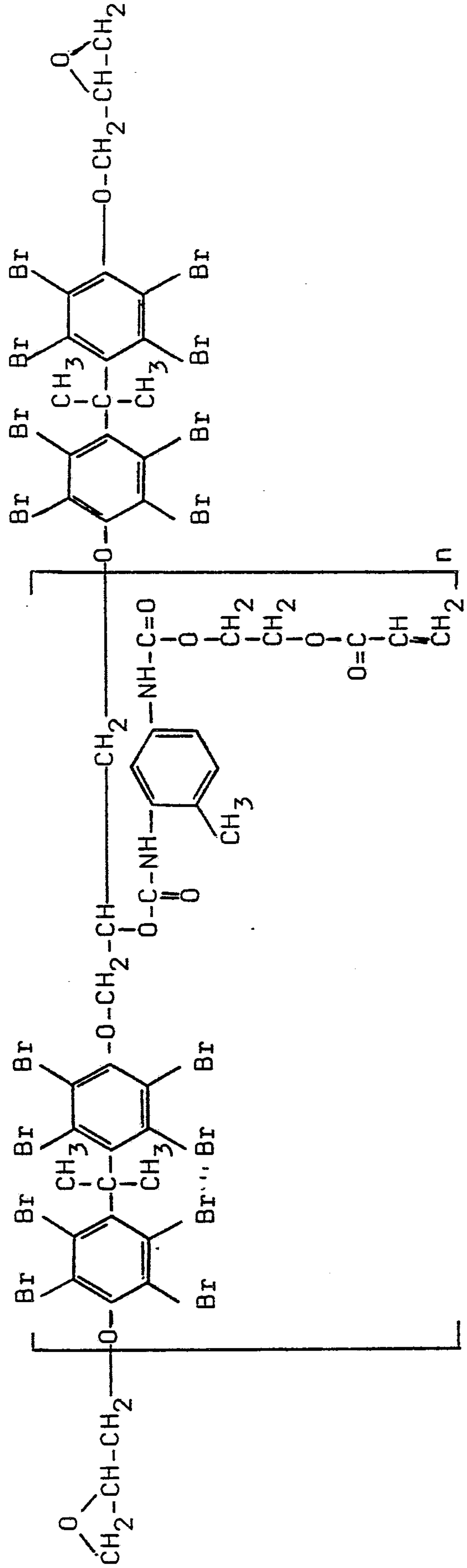

Die Herstellung der erfindungsgemäßen strukturierten Schichten erfolgt, wie bereits ausgeführt, in der Weise, daß das Photopolymere in Form einer Schicht oder Folie auf ein Substrat aufgebracht und mit aktinischem Licht durch eine Maske belichtet oder durch Führen eines Licht-, Elektronen-, Laser-oder Ionenstrahls bestrahlt wird. Anschließend werden die nicht-belichteten bzw. nicht-bestrahlten Schicht-oder Folienteile herausgelöst oder abgezogen und die dabei erhaltenen strukturierten Schichten bzw. Reliefstrukturen gegebenenfalls getempert. Das Photopolymere wird dabei vorteilhaft in einem organischen Lösungsmittel gelöst auf das Substrat aufgebracht. Die Konzentration des Photopolymeren in gängigen Lösungsmitteln, wie Cyclohexanon, $\gamma$-Butyrolacton, N-Methylpyrrolidon und Gemischen davon, kann so eingestellt werden, daß mit bekannten Beschichtungsverfahren, wie Schleudern, Tauchen, Sprühen, Gießen, Rakeln, Bürsten oder Rollen, Schichtstärken von 0,01 bis ca. 500 µm erzeugt werden können. Zur Erzielung einer gleichmäßigen und guten Oberflächenqualität auf Substraten mit glatter Oberfläche haben sich das Gießverfahren (ein derartiges Verfahren ist beispielsweise aus der europäischen Patentschrift 0 002 040 bekannt), das Rakeln und insbesondere die elektrostatische Sprühbeschichtung und das Schleuderbeschichten bei 300 bis 10000 Umdrehungen/Minute als vorteilhaft erwiesen. Bei unebenen Oberflächen, wie Leiterplatten mit Kupfer-Leiterbahnen auf der Oberfläche, sind Schleuderdrehzahlen von 300 bis 1500 vorteilhaft. Der Viskositätsbereich der für das Rakeln, das Sprühen und das Gießverfahren eingesetzten Lacklösungen liegt vorteilhaft zwischen 200 und 1500 mPa.s bei 23°C.

Die auf das Substrat, das vorzugsweise aus Leiterplattenmaterial, Glas, Metall, Kunststoff oder Halbleitern besteht, aufgebrachte Photolackschicht kann bei Raumtemperatur, vorzugsweise bei Temperaturen von 50 bis 80°C, in einem Stickstoff-oder Luftstrom vom Lösungsmittel befreit werden; dabei kann auch im Vakuum gearbeitet oder mit Infrarotstrahlern bzw. auf einer beheizten Platte getrocknet werden.

Zur Erzielung eines ausreichenden Löslichkeitsunterschiedes zwischen den bestrahlten und den nicht-bestrahlten Schicht-bzw. Folienteilen genügen beim erfindungsgemäßen Verfahren, bei Verwendung einer 350 W-Quecksilberhöchstdrucklampe, in Abhängigkeit von der Zusammensetzung und der Schichtstärke Belichtungszeiten zwischen 5 und 400 s. Nach dem Belichten werden, gegebenenfalls nach einem Nachtrocknungsprozeß, die nicht-belichteten Teile mit organischen Lösungsmitteln herausgelöst.

Die nach dem erfindungsgemäßen Verfahren hergestellten strukturierten Schichten bzw. Reliefstrukturen zeichnen sich durch Kantenschärfe, hohe Auflösung, eine rißfreie homogene Oberfläche und eine Wärmeformbeständigkeit aus, die auch den thermischen und mechanischen Beanspruchungen eines Tauchlötprozesses standhält. Die Haftung zum Lot ist sehr gering, so daß, wie erwünscht, keine Lotperlen an der Polymerschicht hängenbleiben. Die erfindungsgemäß hergestellten strukturierten Schichten sind elastisch genug, um Cyceltests zwischen -65 und +125°C ohne Rißbildung zu bestehen. Mit den strukturierten Schichten abgedeckte Schaltungsoberflächen zeigen in Klimatests bei 40°C und 92 % Luftfeuchte unter Spannung (100 V) keine Leiterbahnkorrosion. Derartige Schichten eignen sich also - neben der Anwendung als Lötstoppmasken - auch als wirksame und dauerhafte Schutzschichten gegen Feuchte- und Schadgaseinwirkung.

Die erfindungsgemäßen strukturierten Schichten eignen sich, wegen der - herstellungsbedingt - hohen Reinheit, auch zur Herstellung von Passivierungsschichten auf Halbleiterbauelementen, von Dünn-und Dickfilmschaltungen, von Lötschutzschichten auf Mehrlagenverschaltungen, von Isolierschichten als Bestandteil von Schichtschaltungen und von miniaturisierten Schutz-und Isolierschichten auf elektrisch leitenden und/oder halbleitenden und/oder isolierenden Basismaterialien, und allgemein zur Feinstrukturierung von Substraten und für Strukturübertragungsprozesse, wie Naß-und Trockenätzprozesse, stromlose oder galvanische Metallabscheidung und Aufdampfverfahren, sowie als Masken für die Ionenimplantation. Darüber hinaus eignen sich diese Schichten als Isolier-und Schutzschichten in der Elektrotechnik und in der Mikroelektronik, sowie als Dämpfungsmassen für Oberflächenwellenfilter, insbesondere Fernsehzwischenfrequenzfilter, ferner als Orientierungsschichten in Flüssigkristalldisplays sowie als Dielektrikum bei der Mehrlagenverschaltung.

Anhand von Ausführungsbeispielen soll die Erfindung noch näher erläutert werden.

Beispiel 1

Zu 69 Masseteilen getrocknetes Dichlormethan werden unter Feuchteausschluß 40 Masseteile reines 2.4-Diisocyanatotoluol und zu der dabei erhaltenen Lösung dann bei Raumtemperatur unter Rühren langsam 29,2 Masseteile 2-Hydroxyethylacrylat getropft. Nach 24stündigem Stehen wird durch Titration der Isocyanatgruppen ein 99 %iger Umsatz ermittelt. Das photoreaktive Isocyanat wird mit 250 Masseteilen Petroleumbenzin aus der Reaktionslösung extrahiert und nach Entfernen des Extraktionsmittels als klare viskose Flüssigkeit isoliert;
Ausbeute: 64,5 g, d.h. 93 % der Theorie.

Zu einer Lösung von 100 Masseteilen eines kernbromierten Epoxidharzes auf Basis Bisphenol A (siehe Formel (2); n = 10) in 200 Masseteilen Cyclohexanon werden bei Raumtemperatur und unter Rühren 366 Masseteile trockenes $\gamma$-Butyrolacton, 353 Masseteile trockenes N-Methylpyrrolidon, 131 Masseteile des in der vorstehend beschriebenen Weise isolierten reinen photoreaktiven Monoisocyanats und 0,3 Masseteile Dibutylzinndilaurat gegeben. Nachdem das Gemisch 48 Stunden gerührt wurde, werden zur Reaktionslösung 18 Masseteile Ethanol gegeben. Nach weiteren 24 Stunden sind keine Isocyanatgruppen mehr nachweisbar.

Zu 100 Masseteilen des in der vorstehend beschriebenen Weise - als 23 %ige Harzlösung - hergestellten photoreaktiven Epoxidharzes werden 0,65 Masseteile Benzoinisopropylether, 0,22 Masseteile Michler's Keton, 1,65 Masseteile Trimethylolpropantriacrylat, 0,3 Masseteile Vinyl-tris($\beta$-methoxyethoxy)-silan und 0,2 Masseteile 2-Isopropylimidazol (als Härter) gegeben. Die Lösung wird dann durch ein 5 µm-Filter druckfiltriert. Die Viskosität der dabei erhaltenen Lösung beträgt ca. 300 mPa.s bei 23°C.

Durch Aufschleudern der Lösung bei ca. 500 Umdrehungen/Minute auf eine mit einem Haftvermittler beschichtete Siliciumscheibe werden nach 30minütigem Trocknen bei 70°C in einem Umluftofen 23 µm dicke homogene Schichten erhalten, die nach einer Belichtung von 40 s mit einer 350 W-Quecksilberhöchstdrucklampe durch eine Maske mit $\gamma$-Butyrolacton/Xylol (Volumenverhältnis 1:2) und Nachspülen mit Xylol im Sprühverfahren zu konturenscharfen strukturierten Schichten entwickelt werden. Die Kantenausbildung und die Oberflächenqualität dieser Schichten werden durch einstündiges Tempern bei 150°C nicht beeinträchtigt. Die aufgelösten Strukturen liegen bei ≤ 20 µm.

Eine mit bekannten käuflichen Flußmitteln behandelte photostrukturierte Schicht zeigt nach dem Lötbadtest bei 260°C und 20 s Tauchzeit eine homogene rißfreie Oberfläche. Das Lot perlt von der Lackoberfläche gut ab.

Beispiel 2

Zu einer Lösung von 100 Masseteilen des Epoxidhares Araldit GT 6099 (Araldit® ist ein Warenzeichen der Fa. Ciba-Geigy AG) in 110 Masseteilen Cyclohexanon werden 55 Masseteile reines Isocyanatoethylmethacrylat und 0,15 Masseteile Dibutylzinndilaurat gegeben, dann wird das Gemisch bei Raumtemperatur 24 Stunden gerührt. Danach werden zur Reaktionslösung 17 Masseteile Ethanol gegeben. Nach weiteren 24 Stunden werden 100 Masseteilen der Harzlösung 0,55 Masseteile Dichloracetophenon, 1,65 Masseteile Diethoxyacetophenon, 0,55 Masseteile Michler's Keton, 0,55 Masseteile Vinyl-tris( -methoxyethoxy)-silan und 0,1 Masseteile 2-Isopropylimidazol (als Härter) zugesetzt. Nachfolgend wird die Lösung durch ein 5 µm-Filter druckfiltriert.

Die filtrierte Lösung des photoreaktiven Epoxidharzes wird bei 400 Umdrehungen/Minute auf eine Leiterplatten-Testplatte mit Kupfer-Leiterbahnen auf der Oberfläche geschleudert und danach 1/2 Stunde bei 70°C im Umluftofen getrocknet. Die Dicke der Lackschicht beträgt dann 50 µm. Nach Belichten mit einer 350 W-Quecksilberhöchstdrucklampe durch eine Maske für 10 s und nach 2minütigem Nachtrocknen bei 90°C im Umluftofen werden mit Cyclohexanon als Entwickler, wobei Wasser als Stopper verwendet wird, nach 35 s kantenscharfe strukturierte Schichten erhalten, die - nach einer 30minütigen Aushärtung bei 150°C - in ihrer Oberflächenqualität auch durch hundertmaliges Cyceln zwischen -65 und +125°C nicht beeinträchtigt werden. Diese Schichten widerstehen ebenso unbeschadet Schwall-und Tauchlötprozessen bei 260°C; das Lot perlt von der Oberfläche ab. Feuchtetests bei 40°C und 92 % Luftfeuchte und unter einer Spannung von 100 V zeigen keine Korrosion in den mit Lack abgedeckten Leiterbahnbereichen.

Beispiel 3

Zu 113 Masseteilen getrocknetes Dichlormethan werden unter Feuchteausschluß 62 Masseteile 2.4-Diisocyanatotoluol und danach bei Raumtemperatur und unter Rühren langsam 51,2 Masseteile 2-Hydroxyethylmethacrylat getropft. Nach einer Reaktionsdauer von 24 Stunden bei Raumtemperatur wird der Isocyanatumsatz titrimetrisch zu 99 % ermittelt. Durch Zugabe von 450 Masseteilen Petroleumbenzin wird ein Niederschlag von weißen Kristallen erhalten. Die Ausbeute an reinem photoreaktiven Monoisocyanat beträgt 105 Masseteile bzw. 93 % der Theorie.

Zu einer Lösung von 87 Masseteilen des in der beschriebenen Weise hergestellten photoreaktiven Monoisocyanats in einem Gemisch von 170 Masseteilen γ-Butyrolacton, 138 Masseteilen N-Methylpyrrolidon und 0,015 Masseteilen Dibutylzinndilaurat werden unter Feuchteausschluß 63 Masseteile des Epoxidharzes Araldit GT 6099 gegeben und unter Rühren 12 Stunden bei 50°C zur Reaktion gebracht. Danach werden bei dieser Temperatur zur Reaktionslösung zunächst 8 Masseteile 2-Hydroxyethylmethacrylat und nach weiteren 5 Stunden 4 Masseteile Ethanol gegeben. Nach 24 Stunden hat die Harzlösung eine Viskosität von ca. 200 mPa.s bei 23°C.

Zu 100 Masseteilen der vorstehend beschriebenen Lösung werden 1,2 Masseteile Isopropylthioxanthon, 0,4 Masseteile Michler's Keton, 2,0 Masseteile Trimethylolpropantriacrylat und 0,4 Masseteile Vinyltriethoxysilan gegeben. Nach Filtration durch ein 5 µm-Filter bei einem Druck von 5 bar werden im Gießverfahren auf Substraten 20 µm dicke Lackschichten hergestellt und mit einer 350 W-Quecksilberhöchstdrucklampe 30 s durch eine Maske bestrahlt. Danach wird die belichtete Schicht bei 90°C 5 min im Umluftofen nachgetrocknet. Die Strukturierung (Dauer: 10 s) erfolgt mittels eines Entwicklergemisches aus γ-Butyrolacton und Xylol (Volumenverhältnis 1:2), wobei mit Xylol abgestoppt wird. Die auf diese Weise hergestellte strukturierte Schicht ist lötbadresistent.

Beispiel 4

Zu einer Lösung von 66,8 Masseteilen reinem 2.4-Diisocyanatotoluol in 115 Masseteilen Dichlormethan wird bei Raumtemperatur unter Rühren und Feuchteausschluß ein Gemisch von 23,6 Masseteilen reinem 2-Hydroxyethylacrylat und 24,8 Masseteilen reinem 2-Hydroxyethylmethacrylat langsam zugetropft. Nach 30stündiger Reaktion bei Raumtemperatur wird durch Titration ein Isocyanatumsatz von 98 % ermittelt.

Die erhaltene Lösung des photoreaktiven Monoisocyanats wird mit einer Lösung von 98 Masseteilen des Epoxidharzes Araldit GT 6099 in 397 Masseteilen γ-Butyrolacton und mit 0,22 Masseteilen Dibutylzinndilaurat vereinigt. Nach 24stündiger Reaktion bei Raumtemperatur werden zur Reaktionslösung 15 Masseteile Ethanol gegeben. Nach weiteren 24 Stunden ist die Lösung für Beschichtungen gebrauchsfertig.

Zu 100 Masseteilen der in der geschilderten Weise hergestellten Lösung des photoreaktiven Epoxidharzes werden 1,2 Masseteile 2.4.6-Trimethyl-benzoylphosphinoxid, 0,3 Masseteile Michler's Keton, 0,3 Masseteile Vinyltriethoxysilan und 30 Masseteile Talkum (als Füllstoff) gegeben. Im Gießverfahren werden dann auf Kupfersubstraten 30 µm dicke Lackschichten hergestellt und mit einer 350 W-Quecksilberhöchstdrucklampe 30 s durch eine Maske bestrahlt. Nach dem Entwickeln mit dem Entwickler entsprechend Beispiel 2 (Dauer: 35 s) werden Strukturen mit glatter rißfreier Oberfläche erhalten, die unter Lötbadbedingungen auch bei 260°C stabil sind. Das Lot haftet nicht an der Lackoberfläche, sondern perlt ab.

## Ansprüche

1. Verfahren zur Herstellung wärmebeständiger strukturierter Schichten auf Epoxidharzbasis durch Auftragen strahlungsempfindlicher löslicher Polymerer in Form einer Schicht oder Folie auf ein Substrat, Bestrahlen der Schicht bzw. Folie durch Negativvorlagen mit aktinischem Licht oder durch Führen eines Licht-, Elektronen-, Laser-oder Ionenstrahls, Entfernen der nicht-bestrahlten Schicht-bzw. Folienteile und gegebenenfalls durch nachfolgendes Tempern, **dadurch gekennzeichnet,** daß Photopolymere in Form von Additionsprodukten von olefinisch ungesättigten Monoisocyanaten mit hydroxylgruppenhaltigen Epoxiden verwendet werden.

2. Verfahren nach Anspruch 1, **dadurch gekennzeichnet,** daß die Photopolymeren zusammen mit licht-oder strahlungsempfindlichen copolymerisationsfähigen Verbindungen, insbesondere acrylat-und methacrylatgruppenhaltigen Verbindungen, eingesetzt werden.

3. Verfahren nach Anspruch 1 oder 2, **dadurch gekennzeichnet,** daß die Photopolymeren zusammen mit Photoinitiatoren und/oder Photosensibilisatoren, insbesondere α-Halogenacetophenonen, Dialkoxyacetophenonen, Benzoylphosphinoxiden und Michler's Keton, eingesetzt werden.

4. Verfahren nach einem der Ansprüche 1 bis 3, **dadurch gekennzeichnet,** daß aromatische Partialstrukturen aufweisende Epoxide, insbesondere mit einem Epoxidäquivalentgewicht zwischen 600 und 6000, verwendet werden.

5. Verfahren nach einem oder mehreren der Ansprüche 1 bis 4, **dadurch gekennzeichnet,** daß als olefinisch ungesättigtes Monoisocyanat ein methacrylatgruppenhaltiges Isocyanat oder ein Additionsprodukt von Hydroxyethyl(meth)acrylat an 2.4-Diisocyanatotoluol verwendet wird.

6. Verfahren nach einem oder mehreren der Ansprüche 1 bis 5, **dadurch gekennzeichnet,** daß Epoxidhärter zugesetzt werden.

7. Verfahren nach einem oder mehreren der Ansprüche 1 bis 6, **dadurch gekennzeichnet,** daß mineralische Füllstoffe zugesetzt werden.

8. Wärmebeständige strukturierte Schicht, hergestellt nach einem oder mehreren der Ansprüche 1 bis 7.

9. Verwendung der strukturierten Schicht nach Anspruch 8 als Lötstopp-und Isolierschicht mit dauerhafter Schutzfunktion in der Feinleitertechnik.

10. Verwendung der strukturierten Schicht nach Anspruch 8 als Resist mit intermediärer Schutzfunktion bei Strukturübertragungsprozessen durch Galvanisieren, Naß-und Trockenätzen sowie durch Ionenimplantation.

11. Verwendung der strukturierten Schicht nach Anspruch 8 als Schutz-und Isolierstoff in der Elektrotechnik, insbesondere in der Halbleitertechnik.

12. Verwendung der strukturierten Schicht nach Anspruch 8 als Dämpfungsmasse für Oberflächenwellenfilter.

13. Verwendung der strukturierten Schicht nach Anspruch 8 als α-Strahlenschutz auf den Zellenfeldern von Speicherbausteinen.

14. Verwendung der strukturierten Schicht nach Anspruch 8 als Orientierungsschicht in Flüssigkristalldisplays.

15. Verwendung der strukturierten Schicht nach Anspruch 8 als Dielektrikum bei der Mehrlagenverschaltung.